Europäisches Patentamt

European Patent Office

Office européen des brevets

(19)

(11) Publication number: **0 425 035 A2**

(12) **EUROPEAN PATENT APPLICATION**

(21) Application number: **90202801.8**

(22) Date of filing: **19.10.90**

(51) Int. Cl.5: **H03K 17/08**

(30) Priority: **23.10.89 GB 8923849**

(43) Date of publication of application:
**02.05.91 Bulletin 91/18**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Schoofs, Franciscus Adrianus**
**Cornelis Maria**
**c/o INTERN. OCTROOIBUREAU B.V., Prof.**
**Holstlaan 6**
**NL-5656 AA Eindhoven(NL)**

(74) Representative: **Schouten, Frans et al**
**INTERNATIONAAL OCTROOIBUREAU B.V.**
**Prof. Holstlaan 6**
**NL-5656 AA Eindhoven(NL)**

(54) Overload protection drive circuit for a power transistor.

(57) An overload protection drive circuit for a power transistor has a sensing transistor (T2) for providing a drain source bypass for the power transistor (T1). The bypass is formed by a first resistor (R11) in series with the drain and a second resistor (R10) in series with the source. The voltage developed across one of the resistors (R10, R11) is arranged to trigger a switching circuit (15) to inhibit drive upon occurrence of a predetermined voltage to prevent excessive drain source current.

FIG.4

EP 0 425 035 A2

## OVERLOAD PROTECTION DRIVE CIRCUIT FOR A POWER TRANSISTOR.

The present invention relates to a high voltage semiconductor switching system with overcurrent protection such as may be employed in a switch mode power supply.

In such power supplies used for example in power conversion a half bridge can be considered as a basic function. It consists of a branch formed by two transistors in series connected between a pair of supply lines. An output signal is generated by switching the transistors on and off alternately to connect the positive or negative supply line to the output. A single branch of switches is called a half bridge. The load is connected e.g. between the mid point of the bridge output and a branch of two capacitors connected in series between the supply lines. Two branches are called a full bridge and the load in that case is connected between two mid points.

Three branches form a three phase bridge which may be used e.g. for speed control with electronically commutated motors.

The price of discrete power MOS transistors is now low enough for electronic h.f. commutation to be used instead of 50Hz mains and for viability cheaper components with smaller silicon area to be employed with the consequent risk of damage through overcurrent.

The present invention is concerned with providing overload protection of such arrangements. One method of protection is the application of so called "sense-FETs" in which the transistor has separate major and minor parts e.g. not all of the source elements (e.g. hexagons or squares) are interconnected but are separated into two sources in a ratio of one to one thousand. Assuming the source potentials are equal a current division ratio substantially equal to the geometric ratio results and the current through the smaller sensing source (minor source) can be employed to determine the onset of overload. However, this does require an additional terminal on the transistor known as the "Kelvin contact" normally designated K. Accordingly a transistor package of this type has 5 terminals. (Drain, source, gate, sense-source and Kelvin contact) which is more expensive than a 3 terminal package, has a more complex structure and a worse ratio of drain-source on resistance RDSon to area. Another disadvantage of this system is the requirement for a power supply in the monitoring circuit which needs to deliver a static current. The supply for the high voltage side of a half bridge is a particular problem.

One solution with the previously mentioned device is to employ a floating sense source voltage. When the transistor is conducting no current will flow in in the sense source and its voltage will approach the drain voltage. For a particular transistor the drain-source voltage is representative of the transistors dissipation and may be used as a switch off criteria. However, series resistance in the common drain path may lead to erroneous sensing.

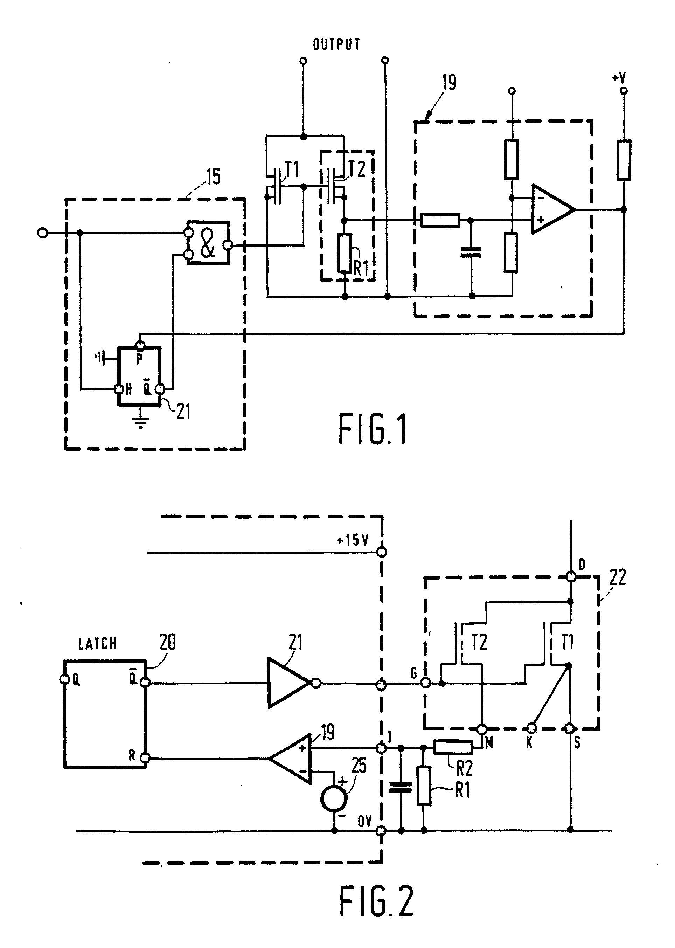

Another proposal known to us is disclosed in French patent specification No. 2591405 reproduced as prior art in Figure 1 of the present application. This arrangement employs a power transistor T1 and a smaller sensing transistor T2 of the same type as T1. A resistor R1 is connected between the two sources of T1 & T2. The voltage across R1 is proportional to VDSon of the power transistor accuracy being higher if R1 ≫ RDSon. This voltage is employed to drive a comparator 19 which determines when the voltage exceeds a predetermined value and triggers a latch 21 which switches off the power transistor. The operation of an MOS transistor as a switch requires a gate to source drive voltage larger than the voltage present between drain and source when a load current is passing through the transistor e.g. VGS = 10 - 15 volts and VDS = 5 - 10 volts are practical values. The power transistor T1 can be considered as a resistor between drain and source when switched on. If the sense source of T2 is unloaded, the voltage appearing on it will be the drain voltage with a maximum value of VGS - V threshold (V threshold e.g. 3 volts). This means that at values of VDS approaching VGS -V threshold this sensing method becomes unusable.

The present invention seeks to overcome some of the disadvantages of the prior art and to permit the production of an integrated circuit drive suitable for driving a simple 3 terminal power transistor and provide overcurrent protection for the power transistor.

According to the invention there is provided an overload protection drive circuit for a power transistor the circuit comprising, a sensing transistor for providing a drain source bypass for the power transistor, which bypass is formed by a first resistor in series with the drain and a second resistor in series with the source and wherein the voltage developed across one of the resistors is arranged to trigger a switching circuit to inhibit drive upon occurrence of a predetermined voltage to prevent excessive drain source current.

In order that the invention and its various other preferred features may be understood more easily, some embodiments thereof will now be described, by way of example only, with reference to the drawings in which:

Figure 1 is a schematic circuit diagram of a power transistor drive circuit of a known design as previously mentioned,

Figure 2 is a schematic circuit diagram of a possible modification of Figure 1,

Figure 3 is a schematic diagram of an alternative integration of the circuit of Figure 3,

Figure 4 is a schematic circuit diagram of a power transistor and drive circuit incorporating the features of the present invention, and

Figure 5 is a schematic circuit diagram similar to Figure 4 incorporating a refinement of the invention.

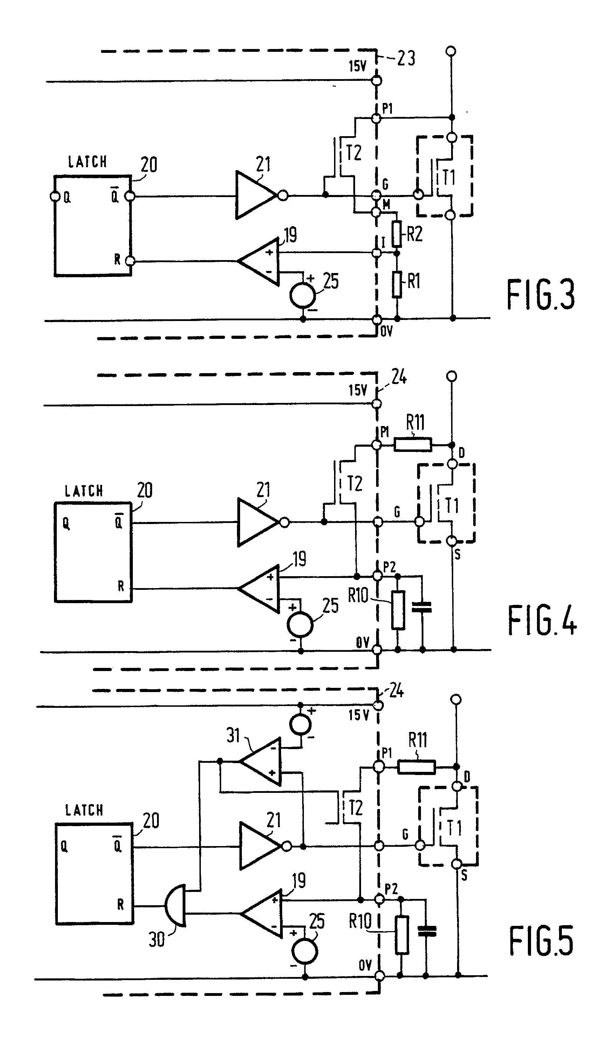

The prior art construction previously described with reference to Figure 1 could be improved by introducing an additional resistor R2 in series with R1 to form a voltage divider, as shown in Figure 2. The Figure 2 circuit illustrates an alternative drive configuration which functions similarly to the construction illustrated in Figure 1 and comprises a comparator 19 the output of which is fed to the reset input R of a latch 20 the Q output of which is fed via an inverter 21 to an output terminal for connection to the gate of sensing transistor T2. The comparator is provided with a reference voltage by block 25. The intermediate junction of the voltage divider is fed to the comparator 19 instead of the source of transistor T2. The advantage of this would be that a fixed reference voltage could be applied to the comparator whilst the circuit could be easily adapted to a variety of devices by changing the external resistors. However, such a sense-FET circuit is more expensive and complex than a standard 3 terminal power transistor and if produced in integrated circuit form with the power transistor it requires at least four terminals as shown at 22 in Figure 2 such sense-FETs are expensive compared with general purpose 3 terminal NMOST transistors. Furthermore, if the sense transistor T2 is fabricated in integrated circuit form together with the drive circuitry as illustrated as 23 in Figure 3 two extra terminals would be required one PI for its drain and the other m for its source as this latter is required for connection to the external resistors R2 and R1 of the voltage divider respectively.

The construction of the present invention is shown in Figure 4 and employs one resistor R10 in the source side of the transistor T2 and another resistor R11 in the drain side of the transistor T2. In such a construction the resistors R10 and R11 still form a voltage divide of the voltage occurring across the power transistor T1 which may be a general purpose NMOST power transistor T1 or any other suitable transistor e.g. insulated gate bipolar transistor. However, the source of the transistor T2 forms also the input for the comparator 19 so that when produced in integrated circuit form 24 the terminal I of Figure 3 is not required and the termination I & M are thereby combined in a single terminal P2. The voltage fed to the comparator is:- VDS (T1) . (R10 + RDSon (T2)/ R 11 + RDSon (T2) + R10 which is the same as provided by the circuit of Figure 3. The voltage division is the same in each case although the RDSon (T2) and upper resistor are interchanged. However, RDSon (T2) has a lower value due to the lower source potential and thus better gate drive in Figure 4.

Although the embodiment illustrated in Figure 4 employs the voltage generated across the resistor R10 in the source side of the transistor T2 to feed the comparator, it should be appreciated that an alternative arrangement would be to sense the voltage across the resistor R11 in the drain side of the transistor. This would require reconfiguration of the circuit with a PMOST transistor (source to positive supply, and gate to interconnection of the resistor R11 and drain of the sense transistor and to assess the presence of current in the PMOST transistor as a switch-off criterion. If a PMOST transistor is used its drain current can be processed in the grounded circuit part. Such constructions are considered to fall within the scope of this invention.

Instead of employing the circuitry 20, 21, 19, illustrated in Figure 4, the circuit illustrated in Figure 1 and comprising the blocks 15 & 19 can be employed.

In the circuit of Figure 4 there can result an undesired behaviour during turn on of the power transistor T1 because the volt drain to source varies across the whole voltage supply range. This can lead to the power transistor being driven into an overload mode of operation and can cause uncertainty as to whether overload is occurring. The modified circuit as shown in Figure 5 seeks to overcome this problem in that the comparator 19 feeds one input of a dual input and AND gate 30 the other input of which if fed from the output of a second comparator 31 which senses the gate voltage of the power transistor T1 and ensures that an output from the AND gate 30 triggers the latch 20 to inhibit drive to the power transistor only when the gate drive voltage thereto approaches the maximum drive voltage.

The overload protection circuit can be employed in combination with power transistors to provide various power supply configurations such configurations are intended to fall within the scope of this invention. Examples of such configurations are:-

1. A half bridge power supply in which two transistors are connected in series and the overload protection drive circuit forms a drain source bypass for one of the power transistors to prevent excessive drain source current.

2. A full bridge power supply circuit having two branches each including two power transistors connected in series and the overload protection drive circuit forms a drain source bypass for one of the power transistors to prevent excessive drain source current.

3. A multiphase drive circuit each phase having a power transistor for supplying phase current and an overload protection drive circuit forming a drain source bypass for the power transistor to prevent excessive drain source current.

4. Both transistors in any branch of the above mentioned examples could have a protection circuit across it.

## Claims

1. An overload protection drive circuit for a power transistor, characterized in a sensing transistor (T2) for providing a drain source bypass for the power transistor (T1), which bypass is formed by a first resistor (R11) in series with the drain and a second resistor (R10) in series with the source and wherein the voltage developed across one of the resistors (R10, R11) is arranged to trigger a switching circuit (19,20,21,25) to inhibit drive upon occurrence of a predetermined voltage to prevent excessive drain source current.

2. A drive circuit as claimed in Claim 1, characterised in that the switching circuit comprises a comparator (19) coupled with said one of the resistors for effecting switching when a preset reference voltage is exceeded.

3. A drive circuit as claimed in Claim 2, characterised in that the switching circuit comprises a latch (20) having an input coupled with the output of the comparator (19) and an output for inhibiting drive upon occurrence of said predetermined voltage.

4. A drive circuit as claimed in any one of the preceding claims, characterised in that means (30,31) are provided to ensure that the switching circuit is enabled to permit inhibition of drive only when the gate voltage of the power transistor approaches the maximum permitted value.

5. A drive circuit as claimed in Claim 4, characterised in that said means to ensure that the switching circuits is enabled comprises an AND gate (30) having an input coupled with the gate of the power transistor (T1) via a comparator (31) and a second input coupled with said one of the resistors via a comparator (19) and an output coupled with a latch (20).

6. A drive circuit as claimed in any one of the preceding Claims, characterised in that it is fabricated on a single integrated circuit chip.

7. A power supply circuit, characterised in the combination of a power transistor (T1) and an overload protection drive circuit as claimed in any one of the preceding claims forming a drain source bypass for the power transistor to prevent excessive drain source current.

8. A half bridge power supply circuit, characterised in the combination of two power transistors connected in series and an overload protection drive circuit as claimed in anyone of Claims 1 to 6 forming a drain source bypass for one of the power transistors to prevent excessive drain source current.

9. A full bridge power supply circuit comprising two branches each including two power transistors connected in series, characterised in the combination of the bridge circuit with two overload protection drive circuits as claimed in any one of Claims 1 to 6 one for each branch each forming a drain source bypass for one of the power transistors in that branch to prevent excessive source current.

10. A multiphase drive circuit, characterised in that provision for each phase of a power transistor for supplying phase current and an overload protection drive circuit as claimed in anyone of Claims 1 to 6 forming a drain source bypass for the power transistor to prevent excessive drain source current.

FIG.1

FIG.2

FIG.3

FIG.4

FIG.5